# EUROPEAN PATENT SPECIFICATION

(11) **EP 1 304 780 B1**
(45) Date of publication and mention of the grant of the patent: **10.05.2017**
(21) Application number: 01124821.8
(22) Date of filing: 18.10.2001
(51) Int. Cl.: H01S 5/12, H01S 5/0625

(54) **A widely tunable semiconductor laser with a grating structure**
Breitverstimmbarer Halbleiterlaser mit Gitterstruktur
Laser à semiconducteur accordable sur bande large

(43) Date of publication of application: 23.04.2003
(73) Proprietor: nanoplus Nanosystems and Technologies GmbH, 97218 Gerbrunn (DE)
(72) Inventor: Kamp, Martin, 97236 Randersacker (DE); Müller, Martin, 97128 Gerbrunn (DE)

(56) References cited:
- EP-A- 0 926 787
- EP-A2- 0 267 667
- US-B1- 6 208 793
- LI G P ET AL: "LONGITUDINAL-MODE SWITCHING IN A TWO-SEGMENT MULTIQUANTUM-WELL DISTRIBUTED-FEEDBACK LASER" JOURNAL OF APPLIED PHYSICS, AMERICAN INSTITUTE OF PHYSICS. NEW YORK, US, vol. 77, no. 9, 1 May 1995 (1995-05-01), pages 4810-4812, XP000504617 ISSN: 0021-8979
- KAMP M ET AL: "Lateral coupling - a material independent way to complex coupled DFB lasers" OPTICAL MATERIALS, ELSEVIER SCIENCE PUBLISHERS B.V. AMSTERDAM, NL, vol. 17, no. 1-2, June 2001 (2001-06), pages 19-25, XP004254783 ISSN: 0925-3467
- MOEHRLE M ET AL: "GIGAHERTZ SELF-PULSATION IN 1.5 M WAVELENGTH MULTISECTION DFB LASERS" IEEE PHOTONICS TECHNOLOGY LETTERS, IEEE INC. NEW YORK, US, vol. 4, no. 9, 1 September 1992 (1992-09-01), pages 976-978, XP000305539 ISSN: 1041-1135
- DATABASE INSPEC [Online] THE INSTITUTION OF ELECTRICAL ENGINEERS, STEVENAGE, GB 1998 PING ZHOU ET AL: 'A binary correlation matrix memory k-NN classifier with hardware implementation' Database accession no. 6208793 & PROCEEDINGS OF BRITISH MACHINE VISION CONFERENCE 14-17 SEPT. 1998 SOUTHAMPTON, UK vol. 1, BMVC 98. PROCEEDINGS OF THE NINTH BRITISH MACHINE VISION CONFERENCE UNIV. SOUTHAMPTON SOUTHAMPTON, UK, pages 214 - 223 VOL.1 ISBN: 1-901725-04-9
- TOHMORI Y ED - INSTITUTE OF ELECTRICAL AND ELECTRONICS ENGINEERS: "Broadly tunable lasers with a super structure grating", PROCEEDINGS OF THE INTERNATIONAL CONFERENCE ON INDIUM PHOSPHIDE AND RELATED MATERIALS. SANTA BARBARA, MAR. 27 - 31, 1994; [PROCEEDINGS OF THE INTERNATIONAL CONFERENCE ON INDIUM PHOSPHIDE AND RELATED MATERIALS], NEW YORK, IEEE, US, vol. CONF. 6, 27 March 1994 (1994-03-27), pages 29-32, XP010118948, DOI: 10.1109/ICIPRM.1994.328152 ISBN: 978-0-7803-1476-4

## Description

### FIELD OF THE INVENTION

The present invention relates to a semiconductor laser with a semiconductor substrate, a laser layer arranged on the semiconductor substrate, a waveguide ridge divided in segments and arranged at a distance from the laser layer, separate contacts to each of the segments and a strip-shaped grating structure arranged lateral to each segment of the ridge and parallel to the laser layer. The present invention further relates to a process for the production of such a semiconductor laser.

### BACKGROUND OF THE INVENTION

Known semiconductor lasers of the type defined in the introduction, also referred to in the art as so called tuneable DFB (distributed feedback) laser diodes, have a grating structure which extends through the laser layer and which facilitates the construction of a monomode laser diode in which, in contrast to multi-mode laser diodes, laser radiation with one specific laser mode is emitted and other modes are suppressed by the grating structure. The standard DFB laser uses a single grating with a certain period in order to achieve laser emission at a fixed wavelength. Tuning of the emission is possible by a variation of the injection current or the temperature of the laser diode, but only over a very limited spectral range. A much wider tuning range can be achieved by using lasers composed of several segments, each one with a specially designed grating structure. Each segment is provided with a contact, which allows to control the drive current of each segment individually. Tuning of the device is accomplished by changing the ratio of the currents through the segments of the laser diode.Such lasers are disclosed in EP0926787 A1 and in G.P. Li et al in Journal of Applied Physics , vol 77, no.9, pages 4810-4812 1995 For the production of tuneable DFB laser diodes with multiple grating structures on the basis of a wafer on a semiconductor substrate base, epitaxy is used to form the structure of the semiconductor wafer on the semiconductor substrate. Previous to the invention the following process has been used to obtain tuneable DFB lasers: For the formation of the grating structures in the laser layer the epitaxial growth is interrupted, when approximately half the layer height of the epitaxial structure has been reached and the grating structure is introduced in a lithographic- and removal process. Then the epitaxial growth is continued. The interruption of the epitaxy in the formation of the laser layer and the following overgrowth of the grating structure introduced into the half-layer induces defects in the laser layer which disadvantageously affect the properties of the laser layers and possibly manifest in a higher current consumption or a reduced life of the laser diodes. The production of the tuneable DFB laser diodes constructed in the known manner proves very costly, in particular due to the production and test process employed and the high reject quota associated therewith.Related prior art is disclosed in US6208793 B1 and in Y. Tohmori, - INSTITUTE OF ELECTRICAL AND ELECTRONICS ENGINEERS: "Broadly tunable lasers with a super structure grating",PROCEEDINGS OF THE INTERNATIONAL CONFERENCE ON INDIUM PHOSPHIDE AND RELATED MATERIALS. SANTA BARBARA, MAR. 27 - 31, 1994; [PROCEEDINGS OF THE INTERNATIONAL CONFERENCE ON INDIUM PHOSPHIDE AND RELATED MATERIALS], NEW YORK, IEEE, US, vol. CONF. 6, 27 March 1994 (1994-03-27), pages 29-32,

### SUMMARY AND OBJECTIVES OF THE INVENTION

The primary objective of the present invention is to propose a tuneable laser diode with a structure which facilitates a simple manufacture of laser diodes. It is also an objective of the present invention to propose a laser layer with an active region which is particularly suited for the realization of lasers with a wide tuning range. A further objective of the present invention is to propose a process particularly suitable for the production of a tuneable DFB laser diode according to the invention. which is defined by claims 1 and 7. According to the invention, a semiconductor laser is provided with a semiconductor substrate. A laser layer is arranged on the semiconductor substrate. An increased tuning range of the laser diode can be achieved by using a laser layer which comprises an active region with a wide range of gain. This can be accomplished by using quantum dots, which have a broadened gain caused by the size and composition distribution of the individual dots. Another possibility is to use an active region with several quantum wells with different thickness or composition. By this means, an improvement of the tuning range compared to lasers with a single quantum well or several identical quantum wells can be obtained.

A waveguide ridge, which is divided in a number of individual segments, is arranged at a distance from the laser layer. In our invention a strip - shaped grating (e.g. by a metal) is formed lateral to at least two of the segments. The grating structures includes two structural regions which are arranged on both sides of the segments of the waveguide ridge and are formed at a distance from the laser layer above the laser layer. If the grating acts as a periodic absorber for the laser radiation, laser emission will occur at a wavelength where the absorption is minimal. If the grating provides amplification, laser emission will occur at a wavelength were to amplification is maximum. For an absorbing grating with a single period, the absorption shows a single minimum at a wavelength determined by the grating period and the effective refractive index of the ridge waveguide. The gratings formed along different sections of the ridge waveguide are composed of several gratings with different grating periods, thereby providing multiple minima of the absorption. In order to form the composed grating, the length of the grating is divided into a number of pixels with a length smaller than the grating period. For each of the pixels, the amplitudes (defined as A = Ao sin (2π x/d), where d is the grating constant) of the constituent gratings are summed. If the sum exceed a certain threshold, the pixel is exposed on the lithographic step of the grating definition, otherwise it is left blank. By changing the amplitudes and periods of the constituent gratings, a flexible control over the spectral position and the magnitude of the dips in the absorption of the grating can be obtained.

The distance between the absorption minima is designed to be different in each grating, so that the minima of the different gratings align only in one particular position. This is where the laser emission will take place.

By changing the drive currents of the segments, the relative position of the absorption minima can be shifted and brought into alignment at a different wavelength. In this manner, a discrete tuning between a set of wavelengths defined by the gratings is possible. If the spacing between the addressable wavelengths is sufficiently small, any intermediate wavelength can be accessed by a simultaneous change of the drive currents in the segments or by a combined variation of the device temperature and of the drive currents.

An embodiment of the invention provides a tuneable DFB laser diode with a grating structure produced following the conclusion of the epitaxial growth of the laser layer for the completion of the semiconductor laser wafer and following the formation of the waveguide ridge. By virtue of this structurally required, subsequent production of the grating structure it is possible to determine the individual amplification spectrum of the laser layer and semiconductor laser wafer before the production of the grating structure in order then, by selective predefinitions of the parameters of the grating structure, to be able to subsequently produce the desired laser profile in an exact manner and thus to be able to reproducibly manufacture tuneable DFB laser diodes with a precisely defined wavelength or laser mode.

The structural design according to the invention also facilitates an undisturbed, continuous formation of the laser layer in the epitaxial process so that unnecessary defects, which can impair the power output characteristic of the laser layer or the DFB laser diode, do not arise at all. The arrangement of the grating structure at a distance from the active laser layer also prevents the subsequent impairment of the laser layer. As the laser layer is grown without interruption the manufacturing cost of tuneable lasers can be strongly reduced.

The grating structure modulates periodically the losses or the gain and the refractive power for light propagating through the laser. In this way the tuneable DFB laser diode according to the invention facilitates a complex coupling of the laser radiation with the grating structure with lateral modulation of the real- and imaginary parts of the refractive index. Laser diodes according to the invention therefore have a high degree of insensitivity to backreflections, which enables them to be used without an optical isolator, for example in applications for optical fiber transmission.

To permit the precisest possible setting of the distance or relative position between the grating structure and the active laser layer of the DFB laser diode in the production of the DFB laser diode, the grating structure can be arranged on a barrier layer arranged in parallel to the laser layer. This upper section of this barrier layer is advantageously realized in a manner suitable to provide electrical insulation between the grating and the laser layer.

If a metal, for example chromium, is used to form the grating structure, the advantageous effects described in the foregoing can be achieved to a particularly comprehensive extend. Irrespectively of the material selected to construct the grating structure, the grating structure can also be formed by material removal, thus not only by material application.

It proves particularly advantageous for the structural regions of the grating structure to be arranged adjacent to the sides of the waveguide ridge and for the width of the waveguide ridge to be dimensioned such that base points of the sides are located in the peripheral region of the radiation emitted from the active zone of the laser layer. This ensures effective coupling between the laser radiation and the grating structure.A single segment laser with such a grating structure is disclosed in KAMP M ET AL: "Lateral coupling - a material independent way to complex coupled DFB lasers" OPTICAL MATERIALS, ELSEVIER SCIENCE PUBLISHERS B.V. AMSTERDAM, NL, vol. 17, no. 1-2, June 2001 (2001-06), pages 19-25, In order to improve the electrical injection the a conductive (e.g. metallic) grating structure is placed on a thin insulation layer (e.g. native or artificial oxide). The thickness of the insulator layer should be small (typically a few nanometers) in order to maintain an effective coupling between the laser radiation and the metal grating. This layer is also used to suppress a potential penetration of the grating material into the semiconductor material of the laser layers and therefore serves as a barrier layer too.

For the optimization of the electrical injection surface and the effects of the grating structure, it also proves advantageous for the sides of the waveguide ridge to be arranged substantially at right angles to the plane in which the grating structure extends, within the accuracy attainable by the manufacturing process.

In a process according to the invention, on the basis of a semiconductor substrate a complete semiconductor laser structure is produced in an epitaxial process with the subsequent formation of a waveguide ridge by subjecting the semiconductor laser structure to a material removal process to form carrier surfaces arranged on both sides of the waveguide ridge and subsequent application of a grating structure on the carries surfaces.

Irrespectively of the material selected to form the grating structure, the grating structure can also be produces by material removal, thus not only by material application.

The processes according to the invention described in the foregoing thus facilitate the production of functional laser diodes in a first process phase, thereby facilitating the precise checking and determination of the electrical and optical properties, thus for example determination of the individual amplification spectrum of the semiconductor wafer used for the laser fabrication. Only thereafter in a second process phase, by the formation of grating structures alongside the waveguide ridge with defined parameters, are the originally multi-mode laser diodes converted into tuneable DFB laser diodes with properties in each case defined as a function of the parameters of the grating structure.

In the event that the grating structure is produced by the application of a grating structure to the carrier surfaces, the use of a lithographic process, in particular the use of an electron beam process with subsequent metallization of the lithographic structure, proves particularly advantageous.

A variant of the production process which is particularly advantageous from the economic standpoint is possible if, for the production of a plurality of DFB laser diodes with different properties, a semiconductor laser wafer is firstly produced by applying an epitaxial structure to a semiconductor substrate, whereupon the waveguide ridges associated with the individual laser diodes are produced in the composite wafer by forming a strip-shaped waveguide structure which is arranged on the surface of the semiconductor laser wafer and which comprises waveguide ridges extending in parallel to one another. Only thereafter is the semiconductor laser wafer divided up into separate semiconductor laser chip units, whereby the properties associated with the individual laser diodes are then precisely defined by the application or implantation of a grating structure with corresponding structural parameters on the surface of a selected number of the laser diodes.

It is thus possible for the laser diodes which have been produced in the composite wafer and are already provided with the waveguide ridge to be used as basic laser diodes or "unfinished" laser diodes with defined electrical and optical properties whereupon, from this reservoir of identically formed basic laser diodes, the required number of laser diodes can then be selected and, by the application or implantation of defined grating structures, the desired number of tuneable DFB laser diodes with precisely defined optical and electrical properties can be produced substantially without rejects.

In the following the construction of an embodiment of a DFB laser diode according to the invention and a possible process for the production thereof will be explained in detail making reference to the drawings.

The various features of novelty which characterize the invention are pointed out with particularity in the claims annexed to and forming a part of this disclosure. For a better understanding of the invention, its operating advantages and specific objects attained by its uses, reference is made to the accompanying drawings and descriptive matter in which preferred embodiments of the invention are illustrated.

### BRIEF DESCRIPTION OF THE DRAWINGS

In the drawings:
Figure 1a is a side view illustrating a stage in the production of a tuneable DFB laser diode with a lateral grating structure;
Figure 1b is a side view illustrating a different stage in the production of a tuneable DFB laser diode with a lateral grating structure;
Figure 1c is a side view illustrating a different stage in the production of a tuneable DFB laser diode with a lateral grating structure;
Figure 1d is a top view illustrating a the same stage as displayed in figure 1c in the production of a tuneable DFB laser diode with a lateral grating structure;
Figure 2a is a scanning electron microscope image of the grating structure arranged on both sides of a waveguide;
Figure 2b is a scanning electron microscope image of the grating structure at one side of the waveguide
Figure 3 is a joined plot of the emission spectrum of the laser for different settings of the drive current through the laser segments
Figure 4 is another joined plot of the emission spectrum of the laser for different settings of the drive currents and the temperature of the laser diode

### DESCRIPTION OF THE PREFERRED EMBODIMENTS

Referring to the drawings in particular, Figure 1a is a simplified perspective view of a semiconductor laser or basic laser diode 10 comprising a semiconductor substrate 11 and an expitaxial structure 12 grown thereon. Part of the epitaxial structure 12 is formed by a laser layer 13 based on a buffer and contact layer 31 and covered at the top by a covering layer 14. In order to allow for a wide spectral tuning range the spectral gain region of the laser layer should be wide while simultaneously maintaining a sufficiently high magnitude of the amplification. The active region in the laser layer can for example consist of a single quantum well or several identical quantum wells. However, for a wide tuning range of the laser diode, an active region formed by one or several layers of quantum dots or several quantum wells with different composition or thickness is preferable.

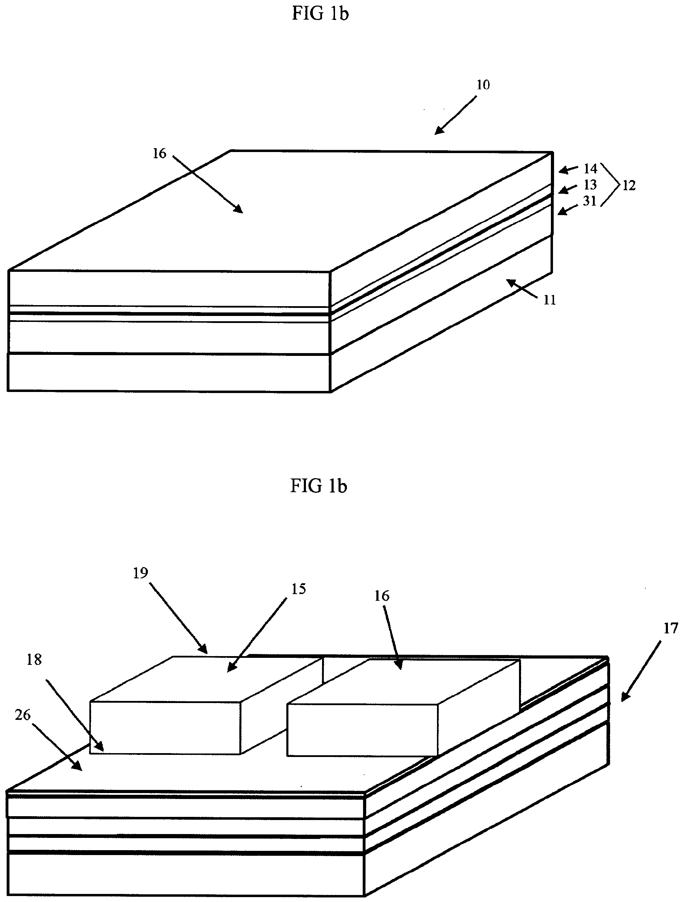

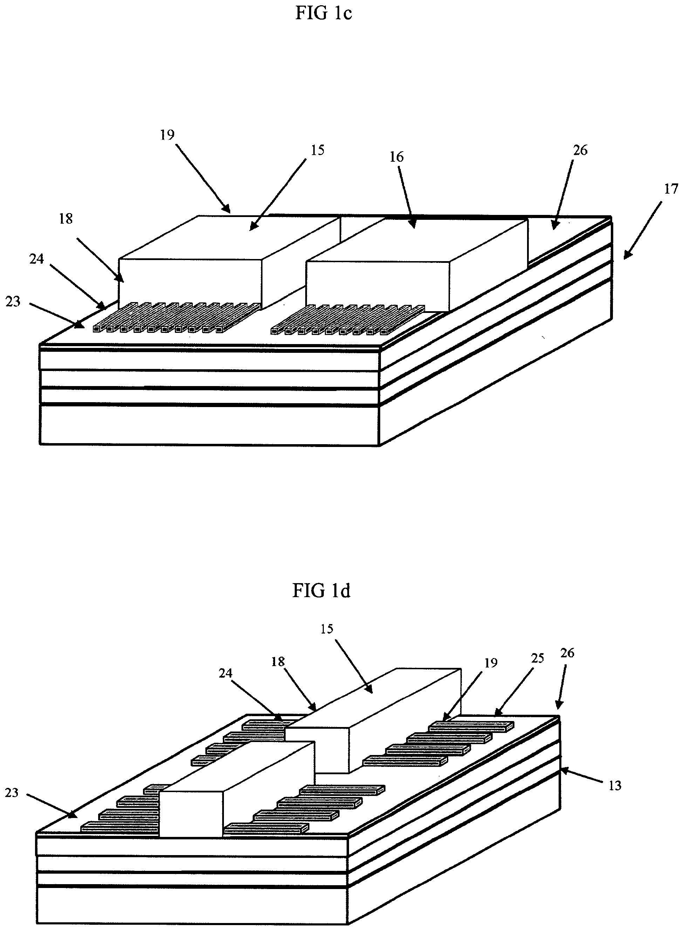

The basic laser diode 10 shown in Figure 1a is of cuboid formation with a flat diode surface 16. Commencing from the basic laser diode 10 illustrated in Figure 1a, the embodiment of a tuneable DFB laser diode 22 according to the invention shown in Figure 1c and 1 d is produced in two essential process phases; as a translational stage following the implementation of a first process phase, Fig. 1b shows a waveguide diode 17 in which the diode surface 16 has been subjected to a material removal process, such as for example a dry etching process, in order to obtain the illustrated stepped surface formation with a waveguide ridge 15 extending in the longitudinal direction of the waveguide diode 17. The aforementioned material removal process gives rise to surfaces which are formed on both sides 18, 19 of the waveguide ridge 15 and which will be referred to in the following as carrier surfaces 20 and 21, the carrier surfaces being covered by a thin insulating layer 26.

Commencing from the waveguide diode 17 illustrated in Figure 1b, the embodiment of a tuneable DFB laser diode 22 shown in figure 1c and 1d is produced by forming e.g. a metallic grating structure 23 with two structural regions 24 and 25 in each case arranged in the carrier surfaces 20 and 21 respectively by subjecting the carrier surfaces 20 and 21 to a lithographic process (e.g. by electron beam lithography) and a following metallization process not described in detail here. This second process phase results in the tuneable DFB laser diode 22 illustrated in Figure 1c and 1d with the metallic grating structure 23 arranged in the carrier surfaces 20 and 21 above the laser layer 13. To be able to precisely define the position of the structural regions 24 and 25 of the metallic grating structure 23 arranged on both sides of the waveguide ridge 15 in the epitaxial structure 12 relative to the laser layer 13, the insulating layer 26, for example in the form of an etch stop layer or an additionally deposited layer, is provided in the expitaxial structure 12, of a lithographic structure produced using an etching propcess and thereby defines the position of the metallic grating structure 23 relative to the laser layer 13.

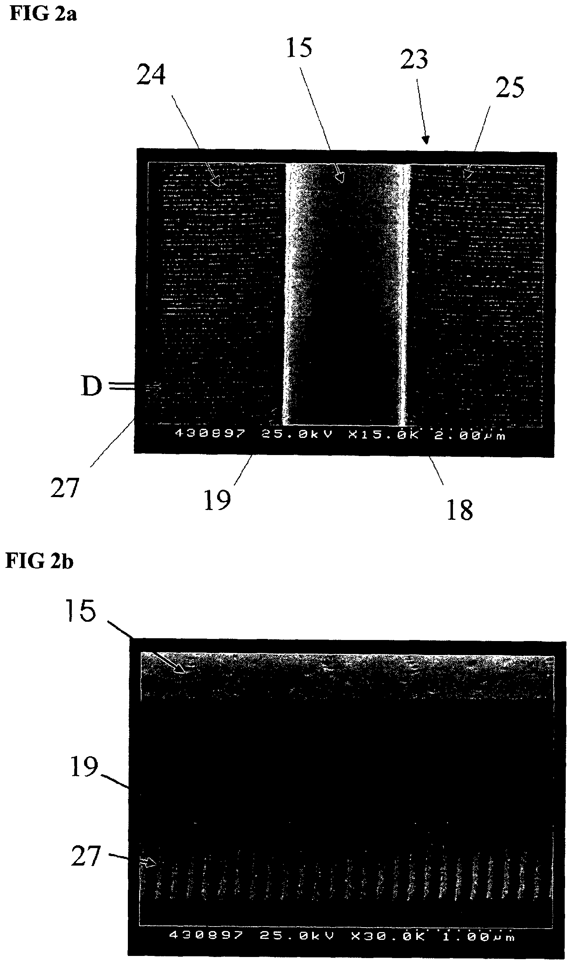

As shown by the electron microscope image of a plan view of the grating (figure 2a and 2b) structure 23 (here made of metal) schematically illustrated in Figure 1c, the structural regions 24 and 25 constructed from grating ridges 27, here arranged equidistantly from one another, extend up to the sides 18 and 19 of the waveguide. The characteristic of the metallic grating structure 23 is determined by the distance between the grating ridges 27 of the grating constant D, the geometric configuration of the grating ridges 27, and the metal used for the metallic grating structure 23.

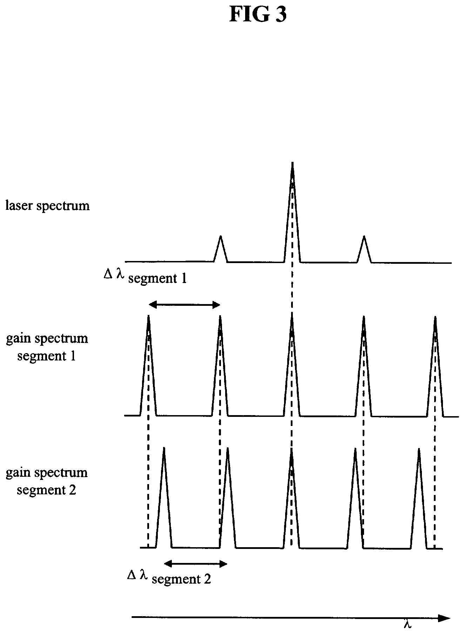

Figure 3 is a qualitative illustration of the selection of the laser wavelength. Two gratings in different segments of the laser have a different spacing of their gain peaks, so their overlap only at one spectral position. The resulting laser spectrum is displayed at the top of figure 3. Tuning can be achieved by displacing the two mode combs of the segments relative to each other by a change of the injection currents.

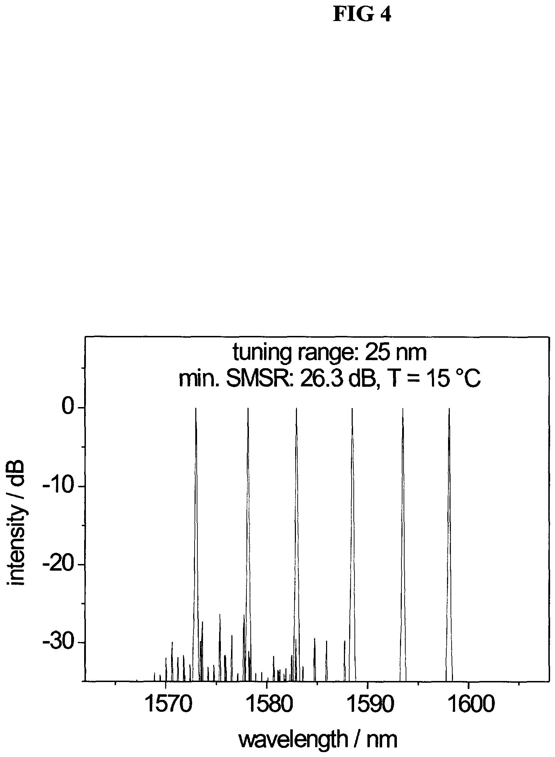

Figure 4 shows a superposition of spectra recorded from a tuneable DFB. Each spectrum was measured for a specific setting of the injection currents in the segments. The spacing of the emission lines corresponds to the spacing of the gain peaks in the segments.

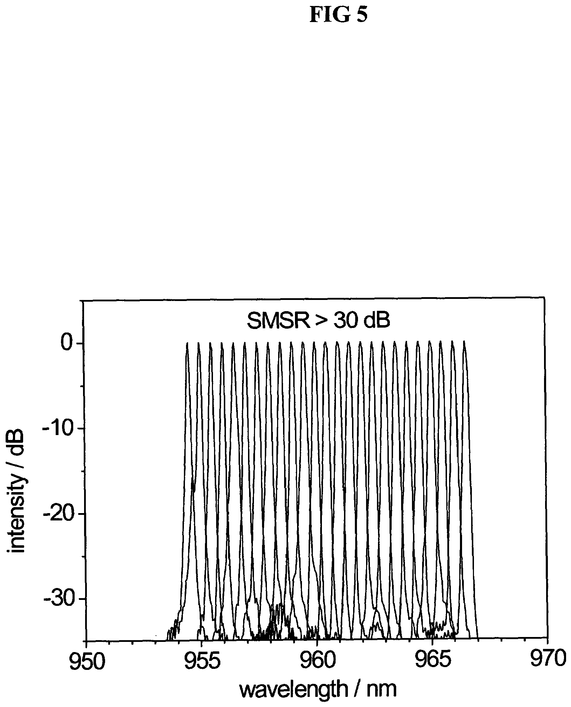

Figure 5 shows the additional possibility of tuning the DFB laser to an emission wavelength between the discrete spectral positions determined by the gratings. In this case, fine tuning is achieved by a simultaneous variation of the injections currents in all segments and/or a change of the temperature of the laser diode.

While specific embodiments of the invention have been shown and described in detail to illustrate the application of the principles of the invention, it will be understood that the invention may be embodied otherwise without departing from such principles.

## Claims

1. A multi segment semiconductor laser, comprising;
a semiconductor substrate (11);
a laser layer (13) arranged on said semiconductor substrate (11)
a waveguide ridge (15) divided in several segments and arranged at a distance from said laser layer (13),
a strip-shaped grating structure (23) arranged lateral to at least two of the segments, said grating structure (23) comprising two structural regions which are arranged on both sides of said waveguide ridge (15) and are formed at a distance from said laser layer (13) above said laser layer (13), and
said grating structure (23) of at least two of the segments are composed of several gratings with different grating periods within the segment, providing multiple absorption minima at different wavelengths.

2. The multi segment semiconductor laser according to claim 1, wherein the active region of the laser layer (13) consists of a layer of quantum dots or several quantum wells with different composition or thickness

3. The multi segment semiconductor laser according to claim 1, wherein said grating structure (23) is arranged on a barrier or insulating layer which defines a position of said grating structure relative (23) to said laser layer.

4. The multi segment semiconductor laser according to claim 1, wherein said grating structure (23) is produced from metal.

5. The multi segment semiconductor laser according to claim 4, wherein said metal is chromium or a chromium alloy.

6. The multi segment semiconductor laser according to claim 1, wherein structural regions of said grating structure (23) are arranged adjacent to sides of said waveguide ridge and said width of said waveguide ridge (15) is dimensioned such that base points of sides of said waveguide ridge (15) are located in a peripheral region of radiation from an active zone of said laser layer (13).

7. A process for said production of a multi segment semiconductor laser based on a semiconductor substrate (11) with a laser layer arranged (12) on said semiconductor substrate and a strip-shaped grating structure (23), the process comprising the steps of:
producing a complete semiconductor laser structure in an epitaxial process;
forming a waveguide ridge (15) divided in several segments by subjecting said semiconductor laser structure to a material removal process to form carrier surfaces (24, 25) on both sides of a waveguide ridge (15); and
applying the grating structure (23), which consists of a composition of several gratings with different grating periods within a single segment, providing multiple absorption minima at different wavelengths, to said carrier surfaces (24, 25)

8. The process according to claim 7, wherein before applying the grating structure (23) to said carrier surfaces an insulating layer (26) is formed on the carrier surfaces (24,25).

9. The process according to claim 8, wherein said step of applying the grating structure (23) includes applying a metallic grating structure (23) with a lithographic process, said lithographic process being employed followed by metallization of said lithographic structure.

10. The process according to claim 9, wherein a plurality of multi segment semiconductor lasers are produced in a composite wafer in according to the steps comprising:
producing a semiconductor laser wafer by application of an epitaxial structure to a semiconductor substrate;
forming the ridge-like waveguide structure comprising waveguide ridges consisting of several segments and extending in parallel to one another on said surface of said semiconductor laser wafer;
dividing said semiconductor laser wafer into individual semiconductor laser chip units;
forming one or more grating structures on said semiconductor laser chip units.

## Patentansprüche

1. Mehrsegment-Halbleiter-Laser, umfassend:
ein Halbleitersubstrat (11);
eine Laserschicht (13), die auf dem Halbleitersubstrat (11) angeordnet ist;
ein Wellenleitersteg (15), der in mehrere Segmente geteilt ist und mit Abstand zur Laserschicht (13) angeordnet ist,
eine streifenförmige Gitterstruktur (23), die seitlich zu zumindest zwei der Segmente angeordnet ist, wobei die Gitterstruktur (23) zwei strukturelle Bereiche umfasst, die an beiden Seiten des Wellenleiterstegs (15) angeordnet sind und mit Abstand zur Laserschicht (13) über der Laserschicht (13) gebildet sind, und
wobei die Gitterstruktur (23) aus zumindest zwei der Segmente aus mehreren Gittern mit verschiedenen Gitterperioden innerhalb des Segments zusammengesetzt sind, mehrere Absorptionsminima bei unterschiedlichen Wellenlängen bereitstellend.

2. Mehrsegment-Halbleiter-Laser nach Anspruch 1, wobei der aktive Bereich der Laserschicht (13) aus einer Schicht von Quantenpunkten oder mehreren Quantentöpfen mit unterschiedlicher Zusammensetzung oder Dicke besteht.

3. Mehrsegment-Halbleiter-Laser nach Anspruch 1, wobei die Gitterstruktur (23) auf einer Sperr- oder Isolierschicht angeordnet ist, die eine Position der Gitterstruktur (23) relativ zur Laserschicht definiert.

4. Mehrsegment-Halbleiter-Laser nach Anspruch 1, wobei die Gitterstruktur (23) aus Metall erzeugt ist.

5. Mehrsegment-Halbleiter-Laser nach Anspruch 4, wobei das Metall Chrom oder eine Chromlegierung ist.

6. Mehrsegment-Halbleiter-Laser nach Anspruch 1, wobei strukturelle Bereiche der Gitterstruktur (23) angrenzend an Seiten des Wellenleiterstegs angeordnet sind und die Breite des Wellenleiterstegs (15) so dimensioniert ist, dass die Basispunkte von Seiten des Wellenleiterstegs (15) in einem peripheren Strahlungsbereich von einer aktiven Zone der Laserschicht (13) gelegen sind.

7. Verfahren zur Herstellung eines Mehrsegment-Halbleiter-Lasers, basierend auf einem Halbleitersubstrat (11) mit einer Laserschicht (12), die auf dem Halbleitersubstrat angeordnet ist, und einer streifenförmigen Gitterstruktur (23), wobei der Verfahren die Schritte umfasst:
Erzeugen einer vollständigen Halbleiter-Laser-Struktur in einem epitaktischen Verfahren;
Bilden eines Wellenleiterstegs (15), der durch Unterziehen der Halbleiter-Laser-Struktur einem Materialentfernungsverfahren, um Trägerflächen (24, 25) an beiden Seiten eines Wellenleiterstegs (15) zu bilden, in einige Segmente geteilt ist; und
Anbringen der Gitterstruktur (23), die aus einer Zusammensetzung mehrerer Gitter mit verschiedenen Gitterperioden innerhalb eines einzelnen Segments besteht, mehrere Absorptionsminima bei verschiedenen Wellenlängen bereitstellend, an den Trägerflächen (24, 25).

8. Verfahren nach Anspruch 7, wobei vor dem Anwenden der Gitterstruktur (23) an die Trägerflächen eine Isolierschicht (26) auf den Trägerflächen (24, 25) gebildet ist.

9. Verfahren nach Anspruch 8, wobei der Schritt zum Anbringen der Gitterstruktur (23) ein Anbringen einer metallischen Gitterstruktur (23) mit einem Lithografieverfahren enthält, wobei das Lithografieverfahren gefolgt von einer Metallisierung der Lithografiestruktur angewendet wird.

10. Verfahren nach Anspruch 9, wobei mehrere Mehrsegment-Halbleiter-Laser in einem Kompositwafer gemäß den Schritten erzeugt werden, umfassend:
Erzeugen eines Halbleiter-Laser-Wafers durch Anbringen einer epitaktischen Struktur an einem Halbleitersubstrat;
Bilden der stegartigen Wellenleiterstruktur, die Wellenleiterstege umfasst, die aus mehreren Segmenten bestehen und sich parallel zueinander auf der Fläche des Halbleiter-Laser-Wafers erstrecken;
Teilen des Halbleiter-Laser-Wafers in einzelne Halbleiter-Laser-Chipeinheiten;
Bilden einer oder mehrerer Gitterstrukturen auf den Halbleiter-Laser-Chipeinheiten.

## Revendications

1. Laser semi-conducteur multi-segment, comprenant;
un substrat semi-conducteur (11) ;
une couche de laser (13) disposée sur ledit substrat semi-conducteur (11)
un guide d'onde à ruban (15) divisé en plusieurs segments et disposé à distance de ladite couche de laser (13),
une structure de réseau en forme de bande (23) disposée à côté d'au moins deux des segments, ladite structure de réseau (23) comprenant deux zones structurelles qui sont disposées sur les deux faces du dudit guide d'onde à ruban (15) et sont formées à distance de ladite couche de laser (13) au-dessus de ladite couche de laser (13), et
ladite structure de réseau (23) d'au moins deux des segments étant composée de plusieurs réseaux à période de réseau différente dans le segment, en procurant des minima d'absorption multiples à différentes longueurs d'onde.

2. Laser semi-conducteur multi-segment selon la revendication 1, dans lequel la zone active de la couche de laser (13) consiste en une couche de puits de points quantiques à composition ou à épaisseur différente.

3. Laser semi-conducteur multi-segment selon la revendication 1, dans lequel ladite structure de réseau (23) est disposée sur une barrière ou une couche isolante qui définit une position de ladite structure de réseau (23) par rapport à ladite couche de laser.

4. Laser semi-conducteur multi-segment selon la revendication 1, dans lequel ladite structure de réseau (23) est produite à partir de métal.

5. Laser semi-conducteur multi-segment selon la revendication 4, dans lequel ledit métal est du chrome ou un alliage de chrome.

6. Laser semi-conducteur multi-segment selon la revendication 1, dans lequel les zones structurelles de ladite structure de réseau (23) sont disposées de manière à être adjacentes aux faces du dit guide d'onde à ruban et ladite largeur dudit guide d'onde à ruban (15) est dimensionnée de manière à ce que les points de base des faces dudit guide d'onde à ruban (15) se situent dans une zone périphérique de radiation en partant d'une zone active de ladite couche de laser (13).

7. Procédé pour ladite production d'un laser semi-conducteur multi-segment à partir d'un substrat semi-conducteur (11) avec une couche de laser disposée (12) sur le dit substrat semi-conducteur et une structure de réseau en forme de bande (23), ce procédé comprenant les étapes suivantes:
production d'une structure de laser à semi-conducteur complète dans un procédé épitaxial ;
formage d'un guide d'onde à ruban (15) divisé en plusieurs segments en soumettant ladite structure de laser semi-conducteur à un processus d'enlèvement de matière pour former des surfaces support (24, 25) sur les deux faces d'un guide d'onde à ruban (15) ; et
application de la structure de réseau (23), qui consiste en une composition de plusieurs réseaux à période de réseau différente dans un seul segment, en procurant des minima d'absorption multiples à différentes longueurs d'onde auxdites surfaces support (24, 25).

8. Procédé selon la revendication 7, dans lequel, avant d'appliquer la structure de réseau (23) auxdites surfaces support, une couche isolante (26) est formée sur les surfaces support (24, 25).

9. Procédé selon la revendication 8, dans lequel ladite étape d'application de la structure de réseau (23) inclut l'application d'une structure de réseau métallique (23) par un procédé de lithographie, ledit procédé lithographique étant employé et suivi par la métallisation de ladite structure lithographique.

10. Procédé selon la revendication 9, dans lequel une pluralité de lasers semi-conducteurs multi-segment sont produits dans une plaquette composite en suivant les étapes comprenant:
la production d'une plaquette laser par application d'une structure épitaxiale sur un substrat semi-conducteur:
le formage d'une structure de type guide d'onde à ruban comprenant des guides d'onde à ruban consistant en plusieurs segments et s'étendant parallèlement les uns aux autres sur ladite surface de ladite plaquette de laser semi-conducteur ;
la division de ladite plaquette de laser semi-conducteur en unités individuelles de puces de laser semi-conducteur ;
le formage d'une ou plusieurs structures de réseau sur lesdites unités de puces laser semi-conducteur.
